# EUROPEAN PATENT SPECIFICATION

(11) **EP 1 761 932 B1**
(45) Date of publication and mention of the grant of the patent: **28.05.2008**
(21) Application number: 05767848.4
(22) Date of filing: 27.06.2005
(51) Int. Cl.: G11C 7/10, G11C 8/06

(54) **DRAM WITH HALF AND FULL DENSITY OPERATION**
DRAM MIT HALBEM UND VOLLEM DICHTEBETRIEB
MEMOIRE VIVE DYNAMIQUE A MODE DE FONCTIONNEMENT DEMI-DENSITE OU DENSITE TOTALE

(30) Priority: 29.06.2004 US 881500
(43) Date of publication of application: 14.03.2007
(73) Proprietor: Micron Technology, Inc., Boise, ID 83716 (US)
(72) Inventor: JANZEN, Jeffery, W., Boise, ID 83706 (US)
(74) Representative: Joly, Jean-Jacques
(86) International application number: PCT/US2005/022971
(87) International publication number: WO 2006/004777

(56) References cited:
- US-A1- 2003 107 912
- US-A1- 2003 193 829
- US-A1- 2004 032 781

## Description

### FIELD

The present invention relates generally to memory devices and in particular the present invention relates to DRAM and its operation.

### BACKGROUND

Dynamic random access memory (DRAM) can be configured as half density or full density. In a full density memory, each internal row of a memory array allows access of a memory cell, and each cell can be used for storage of a unique bit of data. In a half density memory, each internal row is paired with another, complementary row, so that when data is stored in one memory cell, complementary data is stored in the comparable cell of the complementary row. In a half density memory, two word lines are activated at the same time, one on a digit line, and one on digit line* (its complement). This stores inverted data in each cell which is then used as a reference in differential mode to significantly improve refresh time. Odd rows are not utilized in a half density memory. Full density operation of a memory allows use of the full extent of the number of cells, and therefore can store more data than a comparably sized half density memory. Each cell stores its own individual data, and each cell must be individually refreshed, increasing refresh times.

In current technology, the methodology exists to create parts, such as memories, with longer refresh times. With longer refresh times, and with lower density operation such as in half density memories, a lower operating current is used, and battery life for portable type devices has been extended. Portable devices often do not have the requirements for a large amount of memory, especially during most normal modes of operation. Some devices, however, eventually use more memory, and therefore require full density memory despite the fact that it is not always needed. When full density memory is used in components and devices that do not need the full density memory except on certain occasions, power consumption is high, and for limited battery power, such full time full density operation is less than desirable, leading to shorter battery life and the like. On the other hand, certain applications, from portable applications to more powerful portable applications like portable computers and the like, require a greater amount of memory, but still have power constraints.

Memory is typically configured either as half density of as full density, and is not changeable. For the reasons stated above, and for other reasons stated below which will become apparent to those skilled in the art upon reading and understanding the present specification, there is a need in the art for a memory device and method of operating a memory that combines the benefits of half density and full density operation.

US 2003/0193829 discloses a memory as indicated in the preamble of claim 2.

### SUMMARY

The above-mentioned problems and other problems are addressed by the present invention and will be understood by reading and studying the following specification.

The invention is defined by claims 1 and 2.

### BRIEF DESCRIPTION OF DRAWINGS

Figure 1 is a partial circuit diagram of a full density memory device;
Figure 2 is a partial circuit diagram of a half density memory device;
Figure 3 is a flow chart diagram of a method according to one embodiment of the present invention;
Figure 4 is a flow chart diagram of a refresh scrubbing operation according to another embodiment of the present invention; and
Figure 5 is a block diagram of a system on which embodiments of the present invention can be practiced.

### DETAILED DESCRIPTION

In the following detailed description of the invention, reference is made to the accompanying drawings that form a part hereof, and in which is shown, by way of illustration, specific embodiments in which the invention may be practiced. In the drawings, like numerals describe substantially similar components throughout the several views. These embodiments are described in sufficient detail to enable those skilled in the art to practice the invention. Other embodiments may be utilized and structural, logical, and electrical changes may be made without departing from the scope of the present invention.

The following detailed description is, therefore, not to be taken in a limiting sense, and the scope of the present invention is defined only by the appended claims, along with the full scope of equivalents to which such claims are entitled.

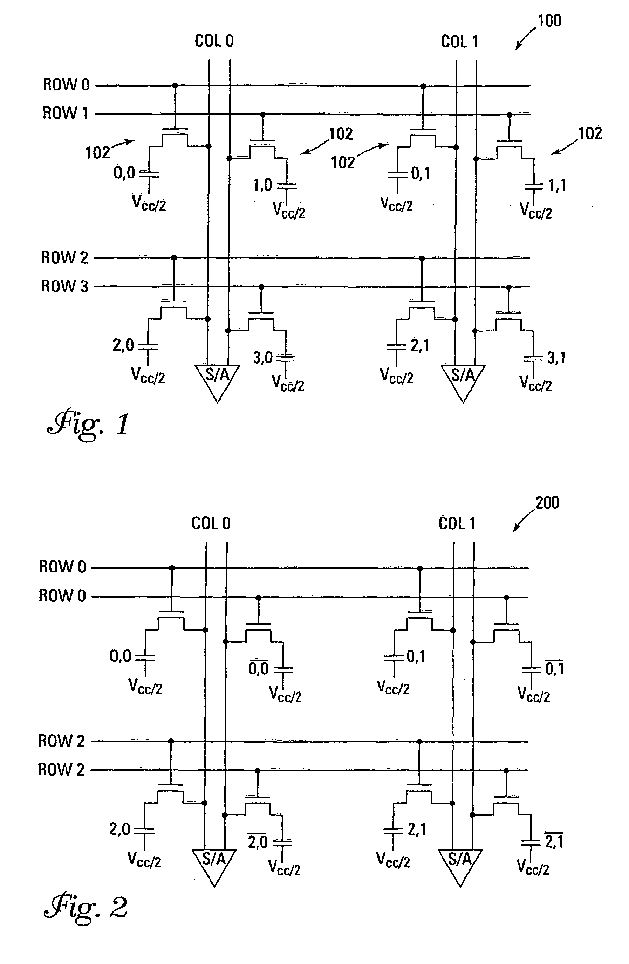

Figure 1 shows a structure of a full density memory 100 upon which embodiments of the present invention can be practiced. Memory 100 comprises an array of memory cells 102 each comprising a transistor and a capacitor, which are addressed by individual internal rows 104 and internal columns 106. These rows 104 and columns 106 as shown can access eight cells, each holding an individual piece of data. For example, to activate cell 0,0, row 0 and column 0 are activated.

Figure 2 shows a structure of a half density memory 200 upon which embodiments of the present invention can be practiced. The structure is equivalent to that of memory 100, but the addressing scheme is different. Memory 200 comprises the same array of memory cells 202 each comprising a transistor and a capacitor, which are addressed by individual internal rows 204 and internal columns 206. However, in the half density memory 200, each row is paired with a complementary row, that is there are two rows 0 and two rows 2 shown. For example, to activate cell 0,0, each of the two row 0s, as well as column 0, are activated. This stores inverted data in cells 0,0 and 0,0*. There are no odd rows used.

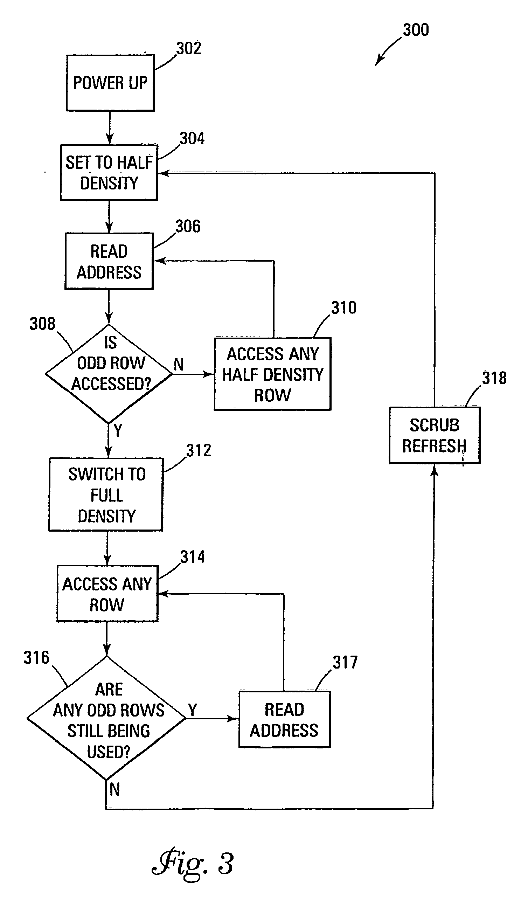

In the embodiments of the present invention, a memory of the same structure as memories 100 and 200 above is used, but the memory operation of the memory is such that it is operable either as a half density memory or as a full density memory, depending upon the desired usage. Such an operation is accomplished using the controller of the memory to operate the memory in the following fashion. In one embodiment 300, shown in flow chart diagram in Figure 3, power up of a memory occurs in block 302. In this embodiment, operation of the memory is set to half density (or 2T) mode in block 304 as a default. It should be understood that a default other and half density, for example full density operation, could also be set without departing from the scope of the invention. In block 306, an address is provided to the memory controller or the like, and in decision block 308, it is determined whether the address is an odd internal row. If the address is not an odd internal row, that is it is an even internal row, then process flow continues at block 310, where any even (half density) internal row is accessible.

Addresses are provided in this manner, filling or using even internal rows until at decision block 308, an odd internal row is accessed. At that point, operation is switched to full density (or 1T) mode in block 312, and any internal row is accessible at block 314. Further, self refresh timings are adjusted with the increased power, so that refresh operations occur at proper intervals. In another embodiment, the most significant external row is mapped to the least significant internal row to aid in system design.

At some point, operation in full density mode will no longer be required. As such, process 300 continues with checking whether any of the odd internal rows are still being used in decision block 316. If odd internal rows are still being used, operation continues in full density mode, with process flow continuing at block 317 with the provision of another address. When no odd internal rows are being used anymore, decision block 316 leads process flow to block 318, where a scrub refresh operation is performed before process flow continues at block 304.

When returning from full density operation to half density operation, there may be some data in odd rows that is no longer needed. That data is expunged when half density operation starts again, because the writing process activates the even word lines, senses the data with the sense amp (that is the correct original data) and then activates the odd word line that is complementary to the even word line. This stores the inverse of the data in the even row cell in the odd row cell when the sense amp fires, and re-writes whatever data was present in the odd row cell. In the transition from full to half density, data on even rows is maintained, but data on odd rows is discarded. In one embodiment, no attempt is made to save data in odd rows. For example, using the configurations shown in Figures 1 and 2, when switching from half density to full density operation, the 0,0 row becomes the 0,1 row.

In another embodiment, the operating system or memory controller organizes data to assure that it is written in appropriate rows before it is provided to the memory. When switching from full density mode to half density mode, in one embodiment, in order to save some data from the odd internal rows, data is stored in a buffer, and then written into an even row before a scrub refresh operation. In another embodiment, the decision to retain data from odd rows is performed on a row by row or even a block by block basis.

For writing to the memory in half density operation, the operating system or memory controller is used to place the data in a location that is consistent with the mode of operation, that is in one of the complementary rows and not the other, in order to allow for the switching only when it is necessary to have more memory density. For example, when operation begins in half density mode, only even rows of the odd/even row pairings are used. When the even rows are full, or as close to full as is logically possible, and the device still needs more memory density, an odd row is written to. Once an odd row is written to, the operating system or memory controller, or a detector that monitors the write locations of data in the memory, initiates full density operation. No data is lost when switching to full density from half density because all that is being done is the elimination of the redundancy built in to half density operation.

At some point, the device may also have a reduced density requirement. At such a time when the required density drops below a threshold for half density operation, the memory switches back to half density operation to save power consumption. If the core memory data is written initially into the lower address rows (the half density rows), then when the memory switches back to half density operation, the data lost is only that data that was added during the full density operation of the system. In one embodiment, the switch to half density operation does not occur until no data is written in any odd internal row.

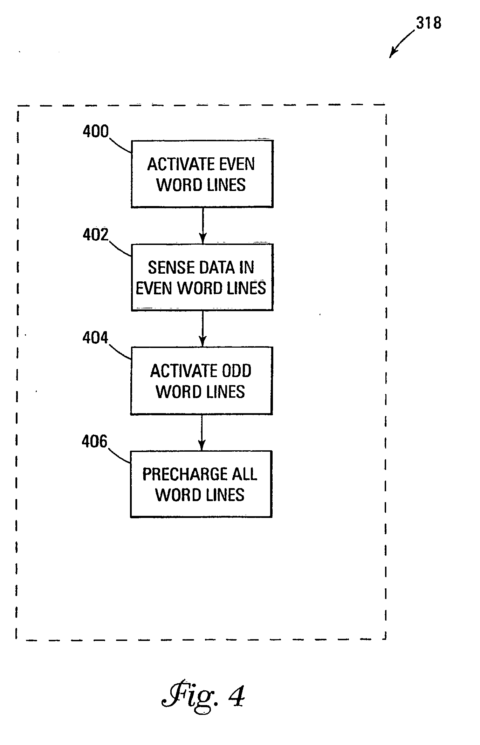

Scrub refresh as indicated at block 318 comprises retaining information in even internal rows when converting from full density operation back to half density operation, and is shown in greater detail in the flow chart diagram of Figure 4. In one embodiment, even word lines are activated in block 400, data is sensed in the sense amplifier for those even word lines in block 402, and odd word lines are activated in block 404 after the sense amplifier after it is stable. This data is the original data stored in the even internal rows. When the sense amp fires, in the half density operation, the inverse of the data in the even internal rows is stored in what had been the odd internal rows but which are now the complementary rows for each even internal row, as is best seen in Figure 2. Both word lines are precharged in block 406, and the original data is stored in the primary cell and its complement is stored in the complementary cell as in normal half density operation. In one embodiment, scrub refresh is a unique command. In another embodiment, scrub refresh is the identical command that was used for any operation during which operation was in half density mode from an earlier operation.

In another embodiment, the usage of the memory is monitored, and when usage drops to a level sufficiently below half usage, the memory then switches back to half density operation. In this embodiment, some data may exist in odd internal rows, and that data must be rewritten into the even internal rows before the switch is made to half density operation. In this embodiment, the operating system monitors the placement of data, and when operation is to be changed from full density to half density, data from rows that are to be erased are read out into a buffer or the like, and then written into rows whose data will be retained when operation switches from full density to half density. Such a check and read/write operation can also be performed in another embodiment on a block by block basis.

In operation, a memory of the present invention functions as follows. A default operation of the memory is initiated upon startup. In one embodiment, the default startup mode of operation is half density operation. On startup, then, the memory operates in half density operation. In this embodiment, only even rows are written to in memory functions, with the odd rows of the array used for redundancy as is known in the art. Writing to the DRAM is made on the even rows until such time as the requirements for density exceed that of the half density operation of the memory. The control program for the memory monitors the addresses to which data is being written. Once an odd row address is encountered, the memory controller switches the operation of the memory to a full density operation, doubling the density of the memory. When only half density is needed, power consumption of the memory is lower than that of a full density operation. However, when the requirements for memory exceed that of a half density operation, full power operation is used, and the increased capacity is available. The memory controller also monitors the density and used portion of the memory once the memory has been switched to a full density memory. As less data is being written to or stored in the memory, there will come a time when half density operation once again is sufficient for the memory. At this time, the memory controller determines that the last odd row data address is no longer needed, or that the density of memory required for the current status of the memory is below a half density threshold. Once this determination has been made, the memory controller switches operation back to half density.

As has been described above, when switching between full density operation and half density operation, data stored in odd rows will be lost. Therefore, the operating system or memory controller monitors the addresses of data to be written to the memory so that only half density operation is used when the memory is operating in half density operation.

As has been discussed, there are no structural difference between typical full density and half density physical layouts. The difference in full and half density modes is in the logic and control of the memory. The embodiments of the present invention use logic shifts to allow half density operation when lower power and less memory density is desired or required, and full density operation when higher densities of storage are required.

In another embodiment, a mode register is used to force the memory into a normal or a half density operation instead of the default power up in half density operational mode. For example, if a 0 is written to the mode register, operation is forced to full density. If a 1 is written to the mode register, operation is forced to half density. Setting the mode register may be accomplished "on the fly" during operation, or at power up or the like. Still further, a specific "reset" command may be invoked by a user to force operation into either full or half density mode of operation. If half density operation is not feasible, a monitor for the memory controller or the operating system does not allow operation in half density until the amount of data to be stored will fit in a half density configuration of the memory. Setting full density operation is in various embodiments accomplished by setting the mode register with a mode register set command, a dedicated input pin, or the like.

In another embodiment, operation is defaulted to half density operation at startup and continues in half density as long as possible, and switches to full density when an odd row is accessed.

The conventions of even and odd rows are used in the description herein. It should be understood that other terminology for such usage occurs, and by even and odd it is meant, respectively, half density only rows as even rows, and full density available rows are odd rows. Other terminology that may be used, by way of example only and not by way of limitation, includes lower address rows for even rows, and upper address rows for odd rows.

A memory controller or other operating system module is used in one embodiment to control the operation of the memory. The controller or operating system can be a machine readable medium that executes instructions in a processor or the like to accomplish the process described herein.

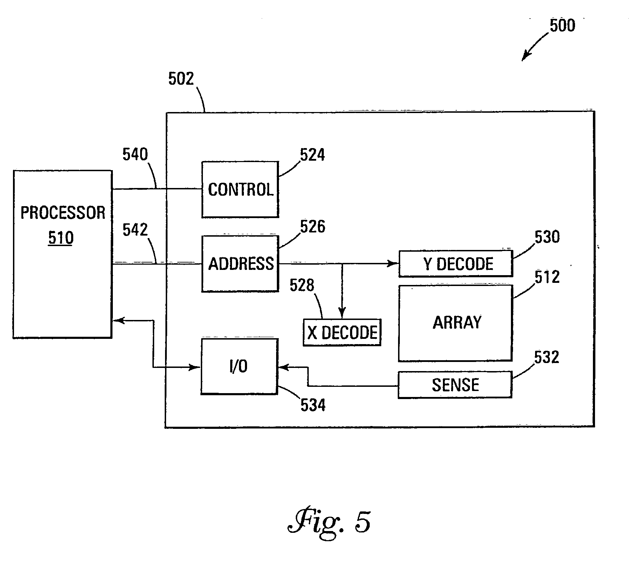

Referring to Figure 5, a simplified block diagram of a system 500 having DRAM 502 of one embodiment of the present invention is described. The memory device can be coupled to a processor 510 for bi-directional data communication. The memory includes an array of memory cells 512. Control circuitry 524 is provided to manage data storage and retrieval from the array in response to control signals 540 from the processor. Address circuitry 526, X-decoder 528 and Y-decoder 530 analyze address signals 542 and storage access locations of the array. Sense circuitry 532 is used to read data from the array and couple output data to I/O circuitry 534. The I/O circuitry operates in a bi-directional manner to receive data from processor 510 and pass this data to array 512. It is noted that the sense circuitry may not be used in some embodiments to store the input data.

Dynamic memories are well known, and those skilled in the art will appreciate that the above-described DRAM has been simplified to provide a basic understanding of DRAM technology and is not intended to describe all of the features of a DRAM.

While data writing has been described herein with half density operation writing data only to even rows, it should be understood that writing data to only odd rows for half density operation is also available. Still further, as long as data is only written to one of a pair of complementary rows, half density operation could use some even rows, and some odd rows. It is sufficient that half of the available memory cells are used so that power consumption is reduced in half density operation.

### Conclusion

Advantages of the various embodiments of the present invention include low power savings that are realized automatically when a reduced quantity of the memory is used. Further, the benefits of full density operation are provided when needed. Still further, the memory can return back to half density operation without losing data stored in the lower half of the memory array.

Further advantages of the various embodiments of the present invention include use in devices which have a limited amount of power available, such as portable devices like handheld computers or personal digital assistants. Application data can in one embodiment be stored in the lower memory array and the memory operates in half density operation when the device is in standby mode or startup mode. Then, temporary data can be stored in the full array during operation. This data can be discarded and the memory returned to its lower power state for standby or sleep modes of the portable device without losing any of the application data.

The embodiments of the invention include a configurable memory (in one embodiment a DRAM) that switches automatically between half density low power operation and full density operation, for increased density as needed by the system. Also disclosed is a method of returning the memory to half density operation for self refresh power savings without losing stored data. During power up, the memory is defaulted to half density operation, with its lowest self refresh power. All operations are in even internal rows until all even internal rows are full. The memory remains in half density operation until an odd internal row is accessed, at which point, the memory automatically converts to normal full density memory operation. The self refresh timings adjust accordingly with increased power of the full density operation.

A reset sequence is added to convert the memory back to half density operation addressing when or if the system desires. A refresh scrubbing operation is added to retain data stored in even rows that were initially used for the half density operation. A scrub refresh embodiment of the present invention comprises activating an even word line, sensing the data in the sense amp (that is the correct original data), activating the odd word line after the sense amp is stable (thus automatically storing inverse data in the cell), precharging both word lines, and storing the original data in the primary cell and complementary data in the other cell as required for half density operation.

Although specific embodiments have been illustrated and described herein, it will be appreciated by those of ordinary skill in the art that any arrangement, which is calculated to achieve the same purpose, may be substituted for the specific embodiment shown. This application is intended to cover any adaptations or variations of the present invention. Therefore, it is manifestly intended that this invention be limited only by the claims and the equivalents thereof

## Claims

1. A method of operating a memory device (100, 200), comprising:
writing data in half density mode only in even internal rows until all such even internal rows are full;
switching to full density mode when an odd internal row is first accessed (308);
writing to any row in full density mode (314);
switching back to half density mode when no odd rows are still required (316),
wherein switching back to half density mode comprises:
organizing remaining odd row data in the memory device so as to write all remaining odd row data into even rows of the memory; and
refresh scrubbing (318), wherein refresh scrubbing (318) comprises:
activating an even word line containing half density data (400);
sensing the data with a sense amplifier (402);
activating an odd word line (404);
precharging both word lines (406); and
storing the organized original data on the even word line and complementary data on the odd word line.

2. A memory (100, 200), comprising:
an array of memory cells (102, 202) addressable by address circuitry;
input/output circuitry to receive external data and to pass the data to the array; and
a memory controller for operating the memory in one of a full density or a half density mode of operation, wherein the memory controller comprises:
means for switching from the half density to the full density mode of operation when half density operation does not have enough density to accommodate all data to be written to the memory, and means for switching back to half density mode when no odd rows are still required,
wherein said means for switching back to half density comprises:
means for refresh scrubbing,
wherein refresh scrubbing comprises:
activating an even word line containing half density data;
sensing the data with a sense amplifier;
activating an odd word line;
precharging both word lines; and
storing the organized original data on the even word line and complementary data on the odd word line,
**characterized by**
data organizing means for
organizing remaining odd row data in the memory device so as to write all remaining odd row data into even rows of the memory.

3. A memory according to claim 2, wherein the memory device is part of a processing system, comprising:
a processor (510) coupled to the memory to store data provided by the processor and to provide data to the processor

4. The method of claim 1, wherein organizing data comprises:
determining what data from odd rows is to be saved;
storing data from odd rows to be saved in a buffer; and
writing the data from odd rows to be saved from the buffer into an even row before a refresh scrubbing.

5. The method of claim 4, wherein determining what data from odd rows is to be saved is performed on a row by row basis.

6. The method of claim 4, wherein determining what data from odd rows is to be saved is performed on a block by block basis.

7. The method of claim 1, wherein switching to half density mode further comprises changing self refresh timings of the memory for half density operation.

8. The method of claim 1, wherein switching back to half density mode further comprises:
monitoring usage of the memory device; and
initiating switching back to half density mode when all data to be stored in the memory can be stored in a half density configuration of the memory device

9. The memory of claim 2, and further comprising:
a buffer; and
wherein organizing odd row data comprises:
determining what data from odd rows is to be saved;
storing data from odd rows to be saved in the buffer; and
writing the data from odd rows to be saved from the buffer into an even row before a refresh scrubbing.

10. The memory of claim 9, wherein determining what data from odd rows is to be saved is performed on a row by row basis.

11. The memory of claim 9, wherein determining what data from odd rows is to be saved is performed on a block by block basis.

12. The memory of claim 2, wherein switching to half density mode further comprises changing self refresh timings of the memory for half density operation.

13. The memory of claim 2, wherein switching back to half density mode further comprises:
monitoring usage of the memory device; and
initiating switching back to half density mode when all data to be stored in the memory can be stored in a half density configuration of the memory device.

## Patentansprüche

1. Verfahren zum Betreiben einer Speichervorrichtung (100, 200), umfassend:
Schreiben von Daten im Modus mit halber Dichte in geradzahlige interne Zeilen bis alle solche geradzahligen internen Zeilen voll sind,
Umschalten auf Modus mit voller Dichte, wenn erstmals auf eine ungeradzahlige interne Zeile zugegriffen wird (308),
Schreiben jeder beliebigen Zeile im Modus mit voller Dichte (314),
Zurückschalten auf Modus mit halber Dichte, wenn keine ungeradzahligen Zeilen mehr benötigt werden (316), wobei das Zurückschalten auf den Modus mit halber Dichte umfaßt:
Organisieren der verbleibenden Daten ungeradzahliger Zeilen in der Speichervorrichtung derart, daß alle verbleibenden Daten ungeradzahliger Zeilen in geradzahlige Zeilen des Speichers geschrieben werden und
Erneuern des Scrubbings (318), wobei das Erneuern des Scrubbings (318) umfaßt:
Aktivieren einer geradzahligen Wordline, die Daten (400) mit halber Dichte enthält,
Lesen der Daten mit einem Leseverstärker (402),
Aktivieren einer ungeradzahligen Wordline (404),
Vorladen beider Wordlines (406) und
Speichern der organisierten Ursprungsdaten auf der geradzahligen Wordline und komplementärer Daten auf der ungeradzahligen Wordline.

2. Speicher (100, 200), umfassend:
ein Array von Speicherzellen (102, 202), die Mittels eines Adreßschaltkreises adressierbar sind,
Eingabe-/Ausgabe-Schaltkreise, um externe Daten zu empfangen und die Daten an das Array weiterzuleiten, und
einen Speichercontroller zum Betreiben des Speichers in entweder einem Betriebsmodus mit voller Dichte oder mit halber Dichte, wobei der Speichercontroller umfaßt:
Mittel zum Umschalten vom Betriebsmodus mit halber Dichte auf volle Dichte, wenn der Betrieb mit halber Dichte keine ausreichende Dichte besitzt, um alle in den Speicher zu schreibenden Daten unterzubringen, und Mittel zum Zurückschalten auf den Modus mit halber Dichte, wenn keine ungeradzahligen Zeilen mehr benötigt werden, wobei die Mittel zum Zurückschalten auf halber Dichte umfassen:
Mittel zum Erneuern des Scrubbings, wobei das Erneuern des Scrubbings umfaßt:
Lesen der Daten mit einem Leseverstärker (402),
Aktivieren einer ungeradzahligen Wordline (404),
Vorladen beider Wordlines (406) und
Speichern der organisierten Ursprungsdaten auf der geradzahligen Wordline und komplementärer Daten auf der ungeradzahligen Wordline,
**gekennzeichnet durch**
Organisieren der verbleibenden Daten ungeradzahliger Zeilen in der Speichervorrichtung derart, daß alle verbleibenden Daten ungeradzahliger Zeilen in geradzahlige Zeilen des Speichers geschrieben werden.

3. Speicher nach Anspruch 2, wobei die Speichervorrichtung Teil eines Verarbeitungssystems ist, umfassend:
einen Prozessor (510), der mit dem Speicher gekoppelt ist, um von dem Prozessor zur Verfügung gestellte Daten zu speichern und dem Prozessor Daten zur Verfügung zu stellen.

4. Verfahren nach Anspruch 1, wobei das Organisieren der Daten umfaßt:
Bestimmen, welche Daten aus ungeradzahligen Zeilen gesichert werden sollen,
Speichern der zu sichernden Daten ungeradzahliger Zeilen in einem Puffer und
Schreiben der zu sichernden Daten ungeradzahliger Zeilen aus dem Puffer in eine geradzahlige Zeile vor dem Erneuern des Scrubbings.

5. Verfahren nach Anspruch 4, wobei das Bestimmen, welche Daten ungeradzahliger Zeilen gesichert werden sollen, auf einer Zeile-für-Zeile-Basis ausgeführt wird.

6. Verfahren nach Anspruch 4, wobei das Bestimmen, welche Daten ungeradzahliger Zeilen gesichert werden sollen, auf einer Block-zu-Block-Basis ausgeführt wird.

7. Verfahren nach Anspruch 1, wobei das Umschalten in den Modus halber Dichte ferner das Verändern des Selbsterneuerungstimings des Speichers für den Betrieb mit halber Dichte umfaßt.

8. Verfahren nach Anspruch 1, wobei das Zurückschalten auf den Modus mit halber Dichte ferner umfaßt:
Überwachen der Verwendung der Speichervorrichtung und
Einleiten eines Zurückschaltens auf den Modus mit halber Dichte, wenn alle in dem Speicher zu speichernden Daten in der Konfiguration der Speichervorrichtung mit halber Dichte gespeichert werden können.

9. Speicher nach Anspruch 2, ferner umfassend:
einen Puffer und
wobei das Organisieren der Daten ungeradzahliger Zeilen umfaßt:
Bestimmen, welche Daten ungeradzahliger Zeilen gesichert werden sollen,
Speichern der zu sichernden Daten ungeradzahliger Zeilen in dem Puffer,
Schreiben der zu sichernden Daten ungeradzahliger Zeilen aus dem Puffer in eine geradzahlige Zeile vor dem Erneuern des Scrubbings.

10. Speicher nach Anspruch 9, wobei das Bestimmen, welche Daten ungeradzahliger Zeilen gesichert werden sollen, auf einer Zeile-für-Zeile-Basis ausgeführt wird.

11. Speicher nach Anspruch 9, wobei das Bestimmen, welche Daten ungeradzahliger Zeilen gesichert werden sollen, auf einer Block-zu-Block-Basis ausgeführt wird.

12. Speicher nach Anspruch 2, wobei das Umschalten in den Modus halber Dichte ferner das Verändern des Selbsterneuerungstimings des Speichers für den Betrieb mit halber Dichte umfaßt.

13. Speichern nach Anspruch 2, wobei das Zurückschalten auf den Modus mit halber Dichte ferner umfaßt:
Überwachen der Verwendung der Speichervorrichtung und
Einleiten eines Zurückschaltens auf den Modus mit halber Dichte, wenn alle in dem Speicher zu speichernden Daten in der Konfiguration der Speichervorrichtung mit halber Dichte gespeichert werden können.

## Revendications

1. Procédé de fonctionnement de dispositif de mémoire (100, 200), comportant :
l'écriture de données à moyenne densité uniquement dans les rangées internes paires jusqu'à ce que toutes ces rangées internes paires soient remplies ;
la commutation en mode haute densité lorsqu'une rangée interne impaire est accédée en premier (308) ;
l'écriture d'une rangée quelconque en mode haute densité (314) ;
le retour en mode moyenne densité lorsqu'aucune rangée impaire n'est plus requise (316), lorsque le retour en mode moyenne densité comprend :
l'organisation des données de rangées impaires restantes dans le dispositif de mémoire de manière à écrire toutes les données de rangées impaires restantes dans les rangées paires de la mémoire ; et
une purge de rafraîchissement (318), où la purge de rafraîchissement (318) comprend :
l'activation d'une ligne de mots paire contenant des données à moyenne densité (400) ;
la détection des données avec un amplificateur de lecture (402) ;
l'activation d'une ligne de mots impaire (404) ;
le préchargement des deux lignes de mots (406) ; et
la mémorisation des données originales organisées sur la ligne de mots paire et les données complémentaires sur la ligne de mots impaire.

2. Mémoire (100, 200), comportant :
un réseau de cellules de mémoire (102, 202) adressables par un circuit d'adresse ;
un circuit d'entrée/sortie pour recevoir les données externes et transférer les données au réseau ; et
un contrôleur de mémoire pour actionner la mémoire dans l'un d'un mode de fonctionnement haute densité ou de moyenne densité, dans lequel le contrôleur de mémoire comprend :
un moyen pour commuter du mode de fonctionnement moyenne densité au mode de fonctionnement haute densité lorsque le fonctionnement moyenne densité ne présente pas assez de densité pour adapter toutes les données à écrire à la mémoire, et un moyen pour revenir en mode moyenne densité lorsqu'aucune rangée impaire n'est plus requise, où ledit moyen pour le retour en moyenne densité comprend :
un moyen de purge de rafraîchissement, dans lequel la purge de rafraîchissement comprend :
l'activation d'une ligne de mots paire contenant des données de moyenne densité ;
la détection des données par un amplificateur de lecture ;
l'activation d'une ligne de mots impaire ;
le préchargement des deux lignes de mots ; et
la mémorisation des données originales organisées sur la ligne de mots paire et les données complémentaires sur la ligne de mots impaire,
**caractérisé par**
un moyen d'organisation de données pour organiser les données de rangées impaires restantes dans le dispositif de mémoire de manière à écrire toutes les données de rangées impaires restantes dans les rangées paires de la mémoire.

3. Mémoire selon la revendication 2, dans laquelle le dispositif de mémoire est une partie d'un système de traitement, comportant :
un processeur (510) couplé à la mémoire pour mémoriser des données délivrées par le processeur et pour délivrer les données au processeur.

4. Procédé selon la revendication 1, dans lequel l'organisation des données comprend :
la détermination des données provenant des rangées impaires qui doivent être sauvegardées ;
la mémorisation des données provenant des rangées impaires à sauvegarder dans un tampon ; et
l'écriture des données provenant des rangées impaires à sauvegarder depuis le tampon dans une rangée paire avant une purge de rafraîchissement.

5. Procédé selon la revendication 4, dans lequel la détermination des données provenant des rangées impaires qui doivent être sauvegardées est effectuée rangée par rangée.

6. Procédé selon la revendication 4, dans lequel la détermination des données provenant des rangées impaires qui doivent être sauvegardées est effectuée bloc par bloc.

7. Procédé selon la revendication 1, dans lequel la commutation en mode moyenne densité comprend en outre le changement des temps de rafraîchissement de la mémoire pour un fonctionnement en moyenne densité.

8. Procédé selon la revendication 1, dans lequel le retour en mode moyenne densité comprend en outre :
le contrôle de l'utilisation du dispositif de mémoire ; et
le déclenchement d'un retour en mode moyenne densité lorsque toutes les données à mémoriser dans la mémoire peuvent être mémorisées dans une configuration moyenne densité du dispositif de mémoire.

9. Mémoire selon la revendication 2, comportant en outre :
un tampon ; et
où l'organisation des données de rangées impaires comprend :
la détermination des données provenant des rangées impaires qui doivent être sauvegardées ;
la mémorisation des données provenant des rangées impaires à sauvegarder dans le tampon ; et
l'écriture des données provenant des rangées impaires à sauvegarder depuis le tampon dans une rangée paire avant une purge de rafraîchissement.

10. Mémoire selon la revendication 9, dans laquelle la détermination des données provenant des rangées impaires qui doivent être sauvegardées est effectuée rangée par rangée.

11. Mémoire selon la revendication 9, dans laquelle la détermination des données provenant des rangées impaires qui doivent être sauvegardées est effectuée bloc par bloc.

12. Mémoire selon la revendication 2, dans laquelle la commutation en mode moyenne densité comprend en outre le changement des temps de rafraîchissement de la mémoire pour un fonctionnement en moyenne densité.

13. Mémoire selon la revendication 2, dans laquelle le retour en mode moyenne densité comprend en outre:
le contrôle de l'utilisation du dispositif de mémoire ; et
le déclenchement du retour en mode moyenne densité lorsque toutes les données à mémoriser dans la mémoire peuvent être mémorisées dans une configuration moyenne densité du dispositif de mémoire.
